Europäisches Patentamt

European Patent Office

Office européen des brevets

(19)

(11) **EP 0 580 461 B1**

(12)

# FASCICULE DE BREVET EUROPEEN

(45) Date de publication et mention
de la délivrance du brevet:
**29.04.1998 Bulletin 1998/18**

(51) Int Cl.6: **H03K 7/06**, H03B 23/00

(21) Numéro de dépôt: **93401506.6**

(22) Date de dépôt: **11.06.1993**

(54) **Dispositif pour la conversion d'une grandeur électrique en une fréquence avec possibilité d'autocalibration de ladite conversion**

Anordnung zur Umwandlung einer elektrischen Grösse in einer Frequenz mit der Möglichkeit zur Autokalibrierung dieser Umwandlung

Apparatus for the conversion of an electrical value in a frequency having the possibility to autocalibrate the conversion

(84) Etats contractants désignés:
**DE GB IT**

(30) Priorité: **21.07.1992 FR 9208973**

(43) Date de publication de la demande:
**26.01.1994 Bulletin 1994/04**

(73) Titulaire: **SEXTANT AVIONIQUE**
**92366 Meudon la Forêt Cédex (FR)**

(72) Inventeurs:
• **Taurand, Christophe**
**F-26000 Valence (FR)**

• **Chevalier, Jean-René**
**F-86100 Chatellerault (FR)**

(74) Mandataire: **de Saint-Palais, Arnaud Marie et al**
**CABINET MOUTARD**
**35, Avenue Victor Hugo**
**78960 Voisins le Bretonneux (FR)**

(56) Documents cités:
EP-A- 0 296 311 WO-A-91/08615
DE-B- 1 964 912 FR-A- 2 256 582
GB-A- 2 107 062

EP 0 580 461 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne un dispositif pour la conversion d'une grandeur électrique telle qu'une tension ou une intensité, en une grandeur discrétisée, avec autocalibration de ladite conversion.

D'une manière générale, pour des applications de type navigation, on sait que les dispositifs de ce genre, généralement appelés CTF ou CIF (convertisseur tension/fréquence ou convertisseur intensité/fréquence) ou même VCO ("voltage controlled oscillator"), ont une fonction de transfert linéaire, et engendrent un signal alternatif ou impulsionnaire dont la fréquence est une fonction affine de la tension ou du courant d'entrée. L'information numérique relative à cette fréquence est habituellement obtenue par comptage des alternances ou des impulsions pendant une période de temps prédéterminée.

Dans un dispositif classique de ce genre (dit, à entrée décalée), la courbe de fréquence en fonction de la tension est une droite tracée entre deux points, à savoir :

- un point correspondant à une fréquence minimum Fmin et à une tension de valeur Vmin, et
- un point correspondant à une fréquence maximum Fmax et à une tension de valeur Vmax.

Il s'avère que les dispositifs de ce genre présentent les inconvénients résultant notamment :

- du bruit de quantification inversement proportionnel à la fréquence (le bruit de quantification étant élevé pour une fréquence faible), et donc de la dissymétrie de résolution entre la partie positive et la partie négative du signal,

- de la dérive thermique importante du dispositif, notamment de la dérive affectant la fréquence Fo correspondant à une tension nulle.

La demande de brevet GB-A-2 107 062 propose un dispositif à deux convertisseurs, le signal d'entrée étant appliqué au premier convertisseur, tandis que le second convertisseur est utilisé pour générer une fréquence de référence, ce qui permet d'éliminer les effets de la dérive thermique. Toutefois, ce document n'indique aucune solution pour supprimer les inconvénients résultant de la dissymétrie de résolution des convertisseurs.

L'invention a donc plus particulièrement pour but de supprimer ces inconvénients au moyen d'un dispositif de conversion qui se prête parfaitement à un processus d'autocalibration cyclique permettant à une unité de traitement, de déterminer en temps réel les paramètres caractéristiques de la fonction de transfert du convertisseur, afin de débiaiser les erreurs de l'électronique (dérives thermiques et à long terme de l'offset, du facteur d'échelle ...) et ce, sans avoir à interrompre la conversion en cours.

Pour parvenir à ces résultats, l'invention propose un dispositif de conversion comprenant :

- au moins deux convertisseurs signal/fréquence par voie, ces convertisseurs générant chacun une fréquence intermédiaire fonction du signal électrique d'entrée à convertir, selon des fonctions de transfert respectives symétriques,
- un calculateur permettant de débiaiser les erreurs et de déterminer une estimation de la grandeur d'entrée à partir des fréquences intermédiaires, en tenant compte des particularités desdites fonctions de transfert.

Avantageusement, le dispositif de conversion précédemment décrit pourra comprendre un dispositif d'autocalibration faisant intervenir :

- des moyens de stimulation permettant d'engendrer, relativement à la fonction de transfert, un nombre de stimuli suffisant pour permettre au calculateur de déterminer, à l'aide d'un modèle préétabli, les paramètres caractéristiques de la fonction de transfert de ce convertisseur,
- des moyens de commutation permettant d'effectuer des séquences d'autocalibration comprenant l'application de stimuli à l'entrée des convertisseurs, puis lorsque le calculateur a déterminé les susdits paramètres, l'application du signal d'entrée sur les convertisseurs.

Dans la plupart des cas, le signal d'entrée consiste en une tension. Dans ce cas, l'un des convertisseurs utilisés pourra présenter par exemple une fonction de transfert selon laquelle la fréquence est fonction affine de la tension d'entrée, pour les valeurs positives de cette tension et est constante pour les valeurs négatives de ladite tension, tandis que l'autre convertisseur pourra alors présenter une fonction de transfert symétrique, la fréquence étant alors une fonction affine de la tension d'entrée, pour les valeurs négatives de celle-ci et constante pour les valeurs positives de cette dernière.

Dans ce cas, les stimuli permettant au calculateur de déterminer les paramètres caractéristiques de la fonction de transfert consistent, pour chacun des convertisseurs, en deux tensions VEN - VON prises sur la partie de la courbe représentative de la fonction de transfert correspondant à des tensions négatives et en deux tensions VOP, VEP prises sur la partie de cette courbe correspondant à des tensions positives.

Ce dispositif "biquadrant" peut être alors associé à une autocalibration basée uniquement sur quatre tensions VEN, VON, VOP, VEP.

On constate que cette solution permet d'obtenir une symétrisation des parties positive et négative du signal et de diminuer la dérive thermique de l'offset (les dérives individuelles des deux convertisseurs ayant tendance à se compenser).

Selon une autre caractéristique de l'invention, les fonctions de transfert des deux convertisseurs consistent en des fonctions affines antisymétriques.

Dans ce cas, l'autocalibration permettant de minimiser en temps réel les erreurs du système sera basée sur trois tensions (stimuli), à savoir : une tension présentant une valeur positive VEP, une tension présentant une valeur négative VEN et une tension présentant une valeur nulle OV.

Cette solution présente l'avantage de travailler à résolution constante et de rendre le bruit de quantification indépendant du niveau du signal d'entrée. En outre, le système est entièrement redondant, de sorte que si l'un des convertisseurs tombe en panne, la conversion peut se poursuivre en mode dégradé avec l'autre convertisseur, ce mode de fonctionnement présentant alors les inconvénients des systèmes classiques précédemment évoqués.

Des modes d'exécution de l'invention seront décrits ci-après, à titre d'exemples non limitatifs, avec référence aux dessins annexés dans lesquels :

La figure 1 est un schéma synoptique d'un système de conversion avec autocalibration cyclique ;

La figure 2 est un schéma synoptique d'un dispositif de conversion de type à aiguillage utilisant deux convertisseurs ayant des fonctions de transfert symétrique ;

La figure 3 est un diagramme tension/fréquence d'entrée, représentatif des fonctions de transfert des convertisseurs utilisés dans le dispositif représenté figure 2 ;

La figure 4 est un schéma synoptique illustrant le principe d'un système d'acquisition continu à autocalibration cyclique, utilisable avec un dispositif de conversion selon l'invention ;

La figure 5 est un chronogramme d'un cycle d'autocalibration effectué par le système représenté sur la figure 4 ;

La figure 6 est un schéma synoptique d'un dispositif de conversion utilisant deux convertisseurs ayant des fonctions de transfert antisymétriques ;

La figure 7 est un diagramme tension/fréquence représentatif des fonctions de transfert des convertisseurs utilisés dans le dispositif illustré figure 6.

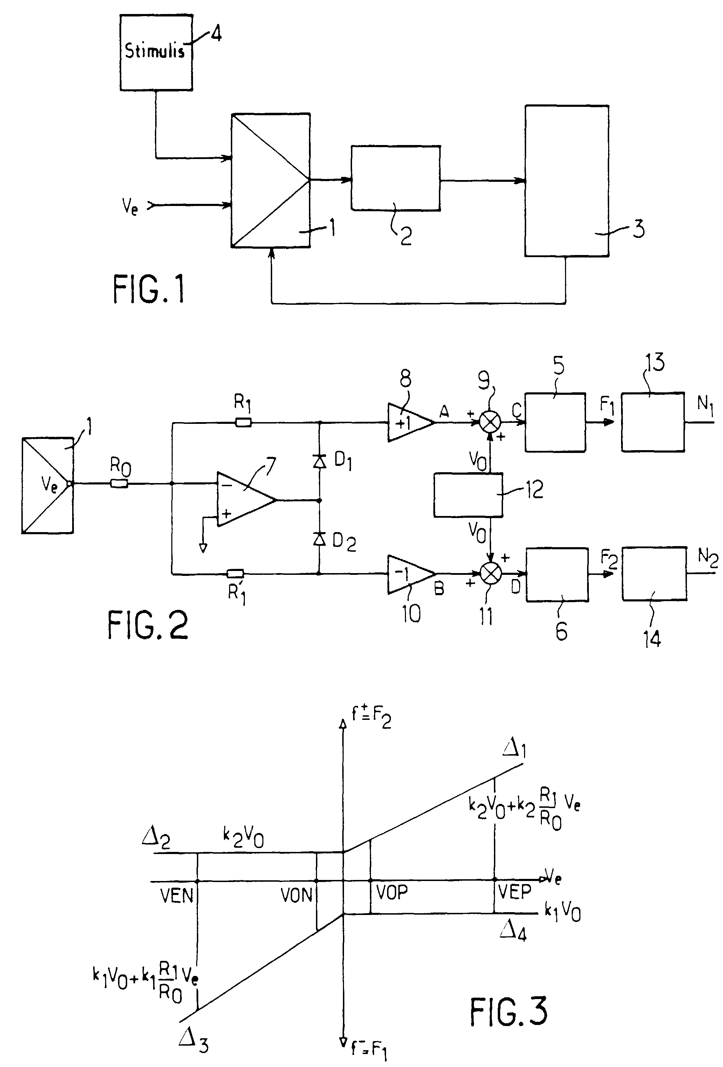

Dans l'exemple représenté sur la figure 1, le signal d'entrée $V_e$ que l' on veut convertir est appliqué, par l'intermédiaire d'un multiplexeur 1, à l'entrée d'un système de numérisation 2 dont la sortie est connectée à un calculateur 3.

Le multiplexeur 1, qui est commandé par le calculateur 3, est relié par une autre entrée à un générateur de stimuli 4 apte à émettre un nombre de stimuli nécessaire pour déterminer précisément la fonction de transfert du système de conversion 2.

A cet effet, le calculateur commande l'aiguillage des stimuli et déduit, de la réponse du système de conversion 2, les divers paramètres de ce système. Une fois ces paramètres déterminés, le calculateur 3 est à même d'effectuer les corrections nécessaires sur les valeurs de fréquence délivrées par le système de conversion 2.

Le système de conversion 2 peut comprendre, comme représenté sur la figure 2, deux convertisseurs tension/fréquence identiques 5, 6 alimentés par un système à aiguillage comprenant un amplificateur opérationnel 7 dont l'entrée inverseuse est reliée à la sortie du multiplexeur 1, par l'intermédiaire d'une résistance $R_0$ et dont la sortie est connectée :

- d'une part, au convertisseur 5, par l'intermédiaire d'une diode $D_1$ montée en sens direct, un amplificateur de gain unitaire 8 et un additionneur 9,
- d'autre part, au convertisseur 6, par l'intermédiaire d'une diode $D_2$ montée en inverse, un amplificateur inverseur 10 et un additionneur 11.

Par ailleurs, l'entrée inverseuse de l'amplificateur opérationnel 7 est reliée à l'entrée de l'amplificateur 8 par l'in-

EP 0 580 461 B1

termédiaire d'une résistance $R_1$, et à l'entrée de l'amplificateur inverseur 10, par l'intermédiaire d'une résistance $R'_1$ dont la valeur est égale à celle de la résistance $R_1$.

Le système de conversion comprend en outre un générateur de tension de référence 12 qui applique une tension $V_o$ sur les deuxièmes entrées des additionneurs 9 et 11.

Les convertisseurs 5 et 6 sont identiques et sont conçus de manière à délivrer à leurs sorties des signaux dont la fréquence est proportionnelle à la tension appliquée sur leurs entrées.

De ce fait, lorsque la tension $V_e$ délivrée par le multiplexeur 1 est positive :

- la tension $V_A$ prélevée à la sortie de l'amplificateur 8 est nulle ($V_A = 0$),
- la tension $V_B$ prélevée à la sortie de l'amplificateur inverseur 10 est donnée par l'expression :

$$V_B = \frac{R'_1}{R_0} V_e$$

- la tension analogique $V_C$ à l'entrée du convertisseur 5 est alors égale à $V_o$, ($V_C = V_o$),
- la tension analogique $V_D$ à l'entrée du convertisseur 6 est donnée par l'expression :

$$V_D = \frac{R'_1}{R_0} V_e + V_o$$

- les fréquences $F_1$ et $F_2$ à la sortie des convertisseurs 5, 6 seront alors données par les expressions :

$$F_1 = k_1 V_o$$

$$F_2 = k_2 V_o + k_2 \frac{R'_1}{R_0} V_e$$

expressions dans lesquelles $k_1$ et $k_2$ sont les gains respectifs des convertisseurs.

D'une façon analogue, lorsque la tension $V_e$ délivrée par le multiplexeur 1 est négative $V_e < O$, les fréquences $F_1$ et $F_2$ sont données par les expressions :

$$\begin{cases} F_1 = k_1 \ V_O + k_1 \dfrac{R1}{R0} \ V_e \\ F_2 = k_2 \ V_O \end{cases}$$

La sortie de chacun des convertisseurs tension/fréquence 5, 6 est connectée à un compteur respectif 13, 14 (faisant éventuellement partie au calculateur 3) qui effectue un comptage du nombre d'impulsions émises au cours d'une même période T. Le nombre d'impulsions comptées, qui est donc proportionnel à la fréquence est alors de la forme :

$$\begin{cases} N_1 = F_1 \ T \\ N_2 = F_2 \ T \end{cases}$$

La fonction de transfert du dispositif de conversion tension/fréquence précédemment décrit est illustrée par le diagramme représenté sur la figure 3 et comprend :

- dans le premier quadrant, une droite $\Delta_1$ répondant à la fonction affine :

4

$$f^+ = F_2 = k_2 V_o + k_2 \frac{R_1}{R_0} V_e$$

- dans le deuxième quadrant, une droite $\Delta_2$ d'équation :

$$f^+ = F_2 = k_2 V_o$$

- dans le troisième quadrant, une droite $\Delta_3$ répondant à la fonction affine :

$$f^- = F_1 = k_1 V_o + k_1 \frac{R_1}{R_0} V_e$$

- dans le quatrième quadrant $\Delta_4$, une droite d'équation :

$$f^- = F_1 = k_1 V_o$$

Il apparaît que quatre stimuli suffisent pour déterminer la fonction de transfert, à savoir :

- deux stimuli consistant en deux valeurs négatives de la tension d'entrée, soit VEN et VON, ces tensions permettant d'obtenir deux points sur chacune des droites $\Delta_2$, $\Delta_3$, et
- deux stimuli consistant en deux valeurs positives de la tension d'entrée, soit VOP et VEP, ces tensions permettant d'obtenir deux points sur chacune des droites $\Delta_1$, $\Delta_4$.

Le circuit précédemment décrit peut servir à l'acquisition d'un signal accélérométrique, la tension $V_e$ étant alors issue d'un accéléromètre et répondant à l'expression :

$$V_e (t) = \alpha \cdot \gamma (t)$$

$\gamma (t)$ exprimant la valeur de l'accélération en fonction du temps.

Dans ce cas, les valeurs $N_1$ et $N_2$ relevées par les compteurs sont de la forme, dans le cas où $R'_1 = R_1$ :

$$\left. \begin{aligned} N_1 &= k_1 \, V_O \, T \\ N_2 &= k_2 \, V_O \, T + k_2 \, \frac{R_1}{R_O} \, \alpha \, \gamma(t) \, T \end{aligned} \right\} \quad V_e > 0$$

$$\left. \begin{aligned} N_1 &= k_1 \, V_O \, T + k_1 \, \frac{R_1}{R_O} \, \alpha \, \gamma(t) \, T \\ N_2 &= k_2 \, V_O \, T \end{aligned} \right\} \quad V_e < 0$$

La soustraction des valeurs $N_2 - N_1$ permet alors d'obtenir :

$$N_2 - N_1 = V_o \, T \, (k_2 - k_1) + k_2 \, \frac{R_1}{R_0} \, \alpha \, \gamma (t).T \qquad (V_e > 0) \qquad (1)$$

$$N_2 - N_1 = V_o \, T \, (k_2 - k_1) - k_1 \, \frac{R_1}{R_0} \, \alpha \, \gamma \, (t) . T \qquad (V_e < 0) \qquad\qquad (2)$$

Les termes :

$$V_o \, T \, (k_2 - k_1) \, ; \, k_2 \, \frac{R_1}{R_0} \, ; \, k_1 \, \frac{R_1}{R_0}$$

pourront être avantageusement évalués grâce à une procédure d'autocalibration cyclique du type de celle qui sera décrite dans la suite de la description.

Dans les expressions (1) et (2), le terme $\gamma \, (t) . T$ correspond à l'accroissement de vitesse $\Delta V$ entre deux instants séparés par la période T.

Dans le cas où, par exemple grâce à un réglage, on s'arrange pour obtenir $k_1 = k_2 = k$, les expressions (1) et (2) deviennent :

$$N_2 - N_1 \, \bigg|_{V_e > 0} = k \, \frac{R_1}{R_0} \, \alpha \, . \, \Delta V \bigg| \, T$$

$$N_2 - N_1 \, \bigg|_{V_e < 0} = k \, \frac{R_1}{R_0} \, \alpha \, . \, \Delta V \bigg| \, T$$

Bien entendu, l'écart $\Delta V$ peut être facilement obtenu à partir de ces deux relations.

Un autre avantage du circuit précédemment décrit consiste en ce qu'il permet de déterminer directement à partir des valeurs $N_1$ et $N_2$ la valeur moyenne de chacune des parties positive ou négative de la courbe de variation de la tension d'entrée.

Cette propriété peut être utilisée notamment dans tous les systèmes utilisant des détections de maxima et minima, surtout dans le cas où les signaux sont bruités.

Ces systèmes peuvent, par exemple, acquérir des capteurs de position de la forme transformateurs différentiels variables linéaires LVDT, etc...

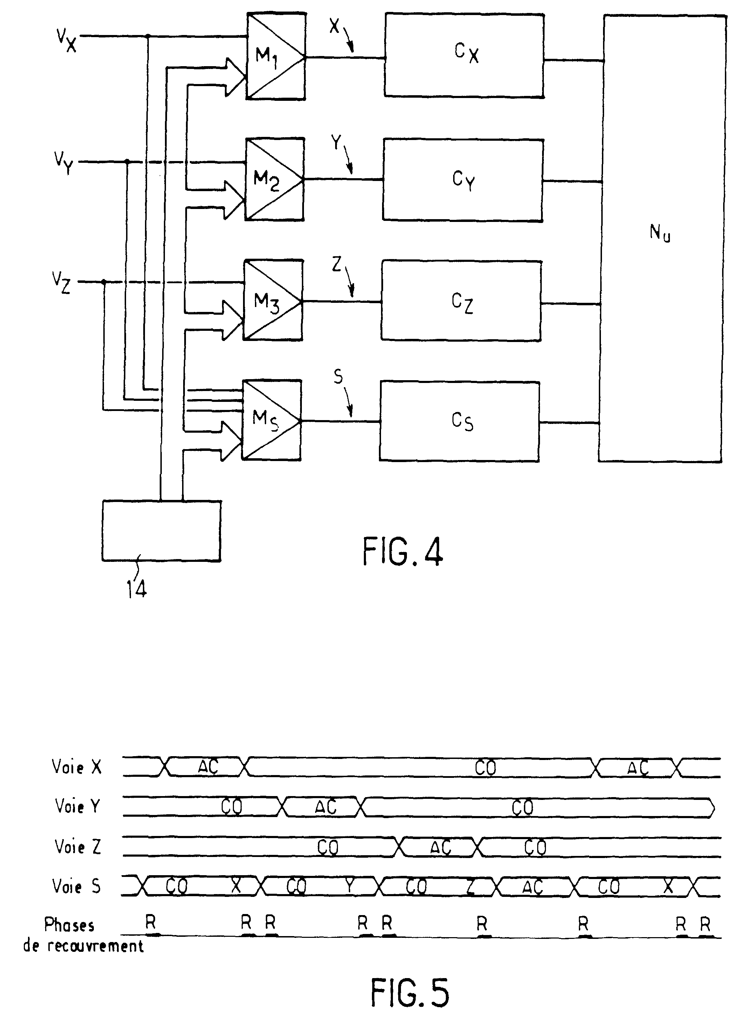

Le système d'acquisition représenté sur la figure 4 comprend trois voies X, Y, Z destinées à traiter trois tensions respectives VX, VY, VZ pouvant par exemple provenir de trois accéléromètres.

Chacune de ces voies X, Y, Z comprend, successivement, un multiplexeur $M_1$, $M_2$, $M_3$ et un dispositif de conversion CX, CY, CZ, par exemple du type de celui représenté sur la figure 2.

Chaque multiplexeur $M_1$, $M_2$, $M_3$ comprend une entrée sur laquelle est appliquée la tension à traiter VX, VY, VZ et est raccordé à un circuit de génération de tensions de référence (stimuli) 14. Les dispositifs convertisseurs CX, CY, CZ sont, quant à eux, reliés par leurs sorties à une unité de traitement numérique $N_u$ (analogue au calculateur 3).

Le système d'acquisition comprend en outre une voie supplémentaire S, dite de substitution, qui comprend de même que les trois autres voies X, Y, Z, un multiplexeur $M_S$ et un dispositif de conversion $C_S$ dont la sortie est reliée à l'unité de traitement $N_u$. Toutefois, dans ce cas, le multiplexeur $M_S$ comprend trois entrées recevant respectivement les tensions VX, VY et VZ, et est raccordé au circuit de génération de tensions de référence.

Le fonctionnement de ce circuit d'autocalibration, qui se trouve illustré par le chronogramme de la figure 5, est alors le suivant :

En vue d'entamer un cycle d'autocalibration d'une voie par exemple la voie X, l'unité de traitement $N_u$ affecte à cette voie, la voie de substitution S et agit sur le multiplexeur $M_S$ de manière à ce qu'il transmette sur sa sortie la tension VX correspondant à cette voie. La voie de substitution S effectue alors la conversion de cette tension VX et transmet à l'unité de calcul $N_u$ le signal numérique résultant de cette conversion, comme s'il s'agissait de la voie que l' on veut calibrer. On assure ainsi la continuité de la mesure de la voie pendant toute la période d'autocalibration de cette voie.

On s'assure alors, lors de phases de recouvrement, de la correspondance des informations fournies par la voie à autocalibrer X et celles de la voie de substitution S.

Ces recouvrements, dont les périodes R sont indiquées sur la figure 5, permettent de vérifier le bon fonctionnement de la voie testée et d'assurer une véritable continuité de l'information que l' on convertit.

Au cours de l' autocalibration, le multiplexeur $M_1$ de la voie à autocalibrer X, transmet successivement au dispositif de conversion CX les stimuli, ici les tensions VEN, VON, VOP, VEP qui, une fois convertis par les deux convertisseurs, permettront à l' unité de traitement $N_u$ de déterminer la fonction de transfert du dispositif de conversion CX.

A la fin de la phase d'autocalibration, on vérifie la correspondance des informations provenant de la voie X que l'on vient d'autocalibrer et celles provenant de la voie de substitution S.

Bien entendu, toutes les voies, y compris la voie de substitution, sont autocalibrées successivement de la façon illustrée figure 5 dans laquelle les périodes d'autocalibration sont désignées par les lettres AC et les périodes de conversion étant désignées par les lettres CO auxquelles est rattachée la lettre X, Y ou Z indiquant le nom de la voie concernée.

Comme précédemment mentionné, cette autocalibration cyclique permet de déterminer en temps réel, à partir d'un modèle, la fonction de transfert du dispositif de conversion, qui débiaise les erreurs propres aux circuits électroniques utilisés (offset, pente ...).

Un avantage supplémentaire que procure cette solution consiste en ce que seuls les composants électroniques utilisés pour la génération des stimuli nécessitent d'être précis.

Bien entendu, l'invention ne se limite pas au mode d'exécution précédemment décrit.

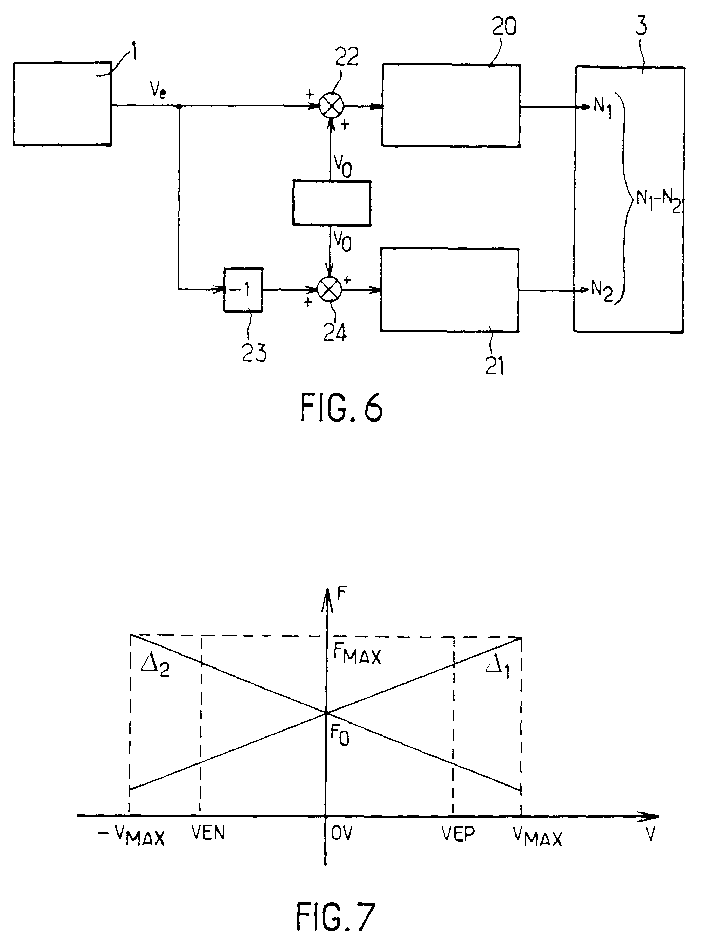

En effet, elle pourrait faire intervenir des dispositifs de conversion présentant des fonctions de transfert différentes par exemple des fonctions de transfert antisymétriques, comme illustré sur les figures 6 et 7.

Dans cet exemple, le dispositif de conversion fait intervenir deux convertisseurs identiques 20, 21 incorporant chacun un compteur qui fournit une valeur numérique $N_1$, $N_2$ proportionnelle à la tension appliquée à l'entrée.

Le convertisseur 20 est relié à la sortie du multiplexeur 1 par l'intermédiaire d'un sommateur 22 qui reçoit sur sa deuxième entrée une tension de référence $V_o$.

L'entrée du convertisseur 21 est, quant à elle, reliée à la sortie du multiplexeur 1 par l'intermédiaire d'un amplificateur inverseur 23 et d'un additionneur 24 sur lequel est appliquée la tension de référence $V_o$.

La tension de référence $V_o$ permet de polariser chacun des systèmes de conversion au milieu de sa pleine échelle (la pleine échelle de la tension délivrée par le multiplexeur 1 étant égale à la moitié de la pleine échelle du convertisseur 20, 21).

Telle qu'illustré sur la figure 7, le diagramme fréquence/tension représentant la fonction de transfert du dispositif de conversion comprend :

- une première droite coupant l'axe des fréquences au point $F_o$ et correspondant à la fonction affine :

$$N_1 = k_1 \, (V_o + V_e)$$

- une deuxième droite coupant également l'axe des fréquences au point $F_o$ et correspondant à la fonction affine :

$$N_2 = k_2 \, (V_o - V_e)$$

En vue d'exploiter les valeurs $N_1$ et $N_2$ fournies par les convertisseurs 20, 21, l'unité de calcul 3 pourra faire la différence $N_1 - N_2$, cette différence ayant pour expression :

$$N_1 - N_2 = V_o \, (k_1 - k_2) + V_e \, (k_1 + k_2)$$

expression dans laquelle :

$(k_1 - k_2) \, V_o$ constitue le faux zéro, et
$(k_1 + k_2)$ est le gain de conversion (égal à la somme des gains).

Un avantage de la solution précédemment décrite consiste en ce qu'elle travaille à résolution constante ; en effet :

$$N_1 + N_2 = V_o \, (k_1 + k_2) + V_e \, (k_1 - k_2)$$

De ce fait, si $k_1 \# k_2$, le terme $V_e \, (k_1 - k_2)$ est négligeable devant $V_o \, (k_1 + k_2)$, qui est une constante. Ceci permet de vérifier à chaque acquisition et sans application d'un stimuli de test, le bon fonctionnement du convertisseur.

Un autre avantage de cette solution réside dans le fait que dans le cas où elles sont identiques, les dérives des systèmes de conversion se compensent pour le faux zéro.

Ainsi, si l'on a :

$$k_1 = k_2 = k \left( 1 + \frac{\Delta k}{k} \right)$$

les expressions de $N_1$ et $N_2$ deviennent :

$$N_1 = k \left( 1 + \frac{\Delta k}{k} \right) (V_0 + V_e)$$

$$N_2 = k \left( 1 + \frac{\Delta k}{k} \right) (V_0 - V_e)$$

On obtient alors :

$$N_1 - N_2 = 2k \left( 1 + \frac{\Delta k}{k} \right) V_e$$

expression dans laquelle le terme en $V_o$ a disparu.

On a donc bien obtenu une compensation des dérives de faux zéro.

Compte tenu du fait que les dérives de gain s'élèvent à $2\Delta k$ et que le facteur d'échelle global est de $2k$, le taux de dérive dont l'expression est :

$$\frac{2\Delta k}{2k} = \frac{\Delta k}{k}$$

est le même que dans un dispositif comportant un seul convertisseur.

Cette solution présente en outre l'avantage de ne nécessiter que trois stimuli pour effectuer l'autocalibration, à savoir les tensions VEN, OV et VEP.

Elle est totalement redondante : dans le cas où l'un des deux convertisseurs tombe en panne, on peut continuer la conversion avec l'autre convertisseur qui fonctionne alors en mode dégradé, (c'est-à-dire avec les inconvénients du convertisseur à fonction de transfert affine).

## Revendications

1. Dispositif pour la conversion d'un signal électrique (Ve) en une fréquence,
   caractérisé en ce qu'il comprend :

   - au moins deux convertisseurs signal/fréquence (5, 6) par voie, ces convertisseurs (5, 6) générant chacun une fréquence intermédiaire ($F_1$, $F_2$) fonction du signal électrique d'entrée (Ve) à convertir, selon des fonctions de transfert respectives symétriques,
   - un calculateur (3) permettant de débiaiser les erreurs et de déterminer une estimation de la grandeur d'entrée ($V_e$) à partir des fréquences intermédiaires ($F_1$, $F_2$), en tenant compte des particularités desdites fonctions de transfert.

2. Dispositif selon la revendication 1,
   caractérisé en ce qu'il comprend un dispositif d'autocalibration faisant intervenir :

   - des moyens de stimulation (14) permettant d'engendrer, relativement à la fonction de transfert, un nombre de stimuli suffisant pour permettre au calculateur ($N_u$) de déterminer, à l'aide d'un modèle préétabli, les paramètres caractéristiques de ladite fonction de transfert,

- des moyens de commutation ($M_1$, $M_2$, $M_3$), permettant d'effectuer des séquences d'autocalibration comprenant l'application de stimuli à l'entrée de l'un des convertisseurs (CX, CY, CZ), puis lorsque le calculateur ($N_u$) a déterminé les susdits paramètres, l'application du signal d'entrée ($V_e$) sur ledit convertisseur (CX, CY, CZ).

3. Dispositif selon l'une des revendications 1 et 2, caractérisé en ce que le signal d'entrée consiste en une tension ($V_e$), et en ce que, dans ce cas, l'un des convertisseurs (5, 6) utilisés présente une fonction de transfert selon laquelle la fréquence est fonction affine de la tension d'entrée ($V_e$), pour les valeurs positives de cette tension ($V_e$) et est constante pour les valeurs négatives de ladite tension, tandis que l'autre convertisseur (6) présente une fonction de transfert symétrique, la fréquence étant une fonction affine de la tension d'entrée ($V_e$), pour les valeurs négatives de celle-ci et constante pour les valeurs positives de cette dernière.

4. Dispositif selon la revendication 3, caractérisé en ce que les stimuli permettant au calculateur de déterminer les paramètres caractéristiques de la fonction de transfert consistent, pour chacun des convertisseurs (5, 6), en deux tensions VEN - VON prises sur la partie de la courbe représentative de la fonction de transfert correspondant à des tensions négatives et en deux tensions VOP, VEP prises sur la partie de cette courbe correspondant à des tensions positives.

5. Dispositif selon l'une des revendications précédentes, caractérisé en ce qu'il comprend deux convertisseurs tensions/fréquences identiques (20, 21) reliés par deux liaisons respectives aux sorties positives et négatives d'un circuit (7, $D_1$, $D_2$) qui reçoit la tension d'entrée ($V_e$) à convertir, l'une desdites liaisons comprenant un sommateur (9) sur lequel est appliquée une tension de référence ($V_o$), tandis que l'autre liaison comprend un amplificateur inverseur (10) et un sommateur (11) sur lequel est appliquée ladite tension de référence ($V_o$).

6. Dispositif selon l'une des revendications 1 et 2, caractérisé en ce que les fonctions de transfert des deux convertisseurs (5, 6) consistent en des fonctions affines antisymétriques vis-à-vis du point correspondant à une tension nulle de fréquence Fo.

7. Dispositif selon la revendication 6, caractérisé en ce que les stimuli permettant au calculateur de déterminer les paramètres caractéristiques de la fonction de transfert consistent en trois tensions (stimuli), à savoir : une tension présentant une valeur positive VEP, une tension présentant une valeur négative VEN et une tension présentant une valeur nulle OV.

8. Dispositif selon l'une des revendications 6 et 7, caractérisé en ce qu'il comprend deux convertisseurs tension/fréquence identiques (20, 21), à savoir : un premier convertisseur (20) qui reçoit sur son entrée la somme de la tension d'entrée ($V_e$) et d'une tension de référence ($V_o$), et un deuxième convertisseur (21) qui reçoit la somme du complément de la tension d'entrée ($V_e$) et de ladite tension de référence ($V_o$).

9. Dispositif selon l'une des revendications précédentes, caractérisé en ce qu'il comporte au moins une voie de conversion (X, Y, Z) affectée au signal que l'on veut convertir, une voie de substitution (S) apte à assurer la conversion dudit signal pendant des phases de calibration de la voie de conversion ainsi que des moyens de commutation ($M_1$, $M_2$, $M_3$) permettant, lors de chaque phase de calibration, d'appliquer le signal sur la voie de substitution (S) et d'appliquer des stimuli sur la voie de conversion (X, Y, Z).

10. Dispositif selon la revendication 9, caractérisé en ce qu'au début et/ou à la fin de chaque phase de calibration, il est prévu un temps de recouvrement (R) au cours duquel les informations émises par la voie de conversion (X, Y, Z) sont comparées aux informations émises par la voie de substitution (S).

**Patentansprüche**

1. Vorrichtung zur Umwandlung eines elektrischen Signals ($V_e$) in eine Frequenz, dadurch gekennzeichnet, daß sie umfaßt:

- wenigstens zwei Signal/Frequenz-Wandler (5, 6) pro Kanal, wobei die Wandler (5, 6) jeweils eine von dem

umzuwandelnden elektrischen Eingangssignal ($V_e$) abhängige Zwischenfrequenz ($F_1$, $F_2$) erzeugen, die den jeweiligen symmetrischen Übertragungsfunktionen entspricht, und

- einen Rechner (3) zur Fehlerkorrektur und zur Bestimmung eines Schätzwertes der Eingangsgröße ($V_e$), ausgehend von Zwischenfrequenzen ($F_1$, $F_2$) und unter Berücksichtigung der Besonderheiten der Übertragungsfunktionen.

2. Vorrichtung nach Anspruch 1, dadurch gekennzeichnet, daß sie eine Vorrichtung zur automatischen Eichung unter Verwendung von:

- Impulserzeugungsmitteln (14) zur Erzeugung einer ausreichenden Anzahl von Stimuli, bezogen auf die Übertragungsfunktion, um dem Rechner ($N_u$) die Bestimmung der charakteristischen Parameter der Übertragungsfunktion unter Zuhilfenahme eines vorgegebenen Modells zu ermöglichen, und
- Kommutationsmitteln ($M_1$, $M_2$, $M_3$) zur Durchführung von Selbsteichungs-Sequenzen, umfassend die Erzeugung von Stimuli am Eingang eines der Wandler (CX, CY, CZ) und die Erzeugung eines Eingangssignals ($V_e$) am Wandler (CX, CY, CZ), sobald der Rechner ($N_u$) die oben erwähnten Parameter bestimmt hat,

umfaßt.

3. Vorrichtung nach einem der Ansprüche 1 oder 2, dadurch gekennzeichnet, daß das Eingangssignal aus einer Spannung ($V_e$) besteht und daß in diesem Fall einer der verwendeten Wandler (5, 6) eine Übertragungsfunktion erzeugt, gemäß welcher die Frequenz bei positiven Spannungswerten eine affine Funktion der Eingangsspannung ($V_e$) und bei negativen Spannungswerten konstant ist, während der andere Wandler (6) eine symmetrische Übertragungsfunktion erzeugt, wobei die Frequenz bei negativen Werten eine affine Funktion der Eingangsspannung ($V_e$) und bei positiven Werten konstant ist.

4. Vorrichtung nach Anspruch 3, dadurch gekennzeichnet, daß die Stimuli, die dem Rechner die Bestimmung der charakteristischen Parameter der Übertragungsfunktion erlauben, bei jedem Wandler (5, 6) aus zwei Spannungen VEN - VON, die dem Teil der die Übertragungsfunktion darstellenden Kurve entnommen sind, der den negativen Spannungen entspricht und aus zwei Spannungen VOP, VEP bestehen, die dem Teil der Kurve entnommen sind, der den positiven Spannungen entspricht.

5. Vorrichtung nach einem der vorhergehenden Ansprüche, dadurch gekennzeichnet, daß sie aus zwei Spannungs/ Frequenz-Wandlern (20, 21) besteht, die durch zwei entsprechende Verbindungen mit dem positiven bzw. negativen Ausgang eines Stromkreises (7, $D_1$, $D_2$) verbunden sind, der die umzuwandelnde Eingangsspannung ($V_e$) empfängt, wobei eine der Verbindungen einen Summator (9) umfaßt, an den eine Vergleichsspannung ($V_o$) angelegt ist, während die andere Verbindung einen invertierenden Verstäker (10) und einen Summator (11) umfaßt, an den die Vergleichsspannung ($V_o$) angelegt ist.

6. Vorrichtung nach einem der Ansprüche 1 und 2, dadurch gekennzeichnet, daß die Übertragungsfunktionen der beiden Wandler (5, 6) aus affinen Funktionen bestehen, die, bezogen auf den Punkt, der einer Spannung von Null mit einer Frequenz $F_o$ entspricht, asymmetrisch sind.

7. Vorrichtung nach Anspruch 6, dadurch gekennzeichnet, daß die Stimuli, die dem Rechner die Bestimmung der charakteristischen Parameter der Übertragungsfunktion erlauben, aus drei Spannungen (Stimuli) bestehen, nämlich: einer Spannung VEP mit einem positiven Wert, einer Spannung VEN mit einem negativen Wert und einer Spannung OV mit dem Wert Null.

8. Vorrichtung nach einem der Ansprüche 6 und 7, dadurch gekennzeichnet, daß sie zwei identische Spannungs/ Frequenz-Wandler (20, 21) umfaßt, nämlich: einen ersten Wandler (20), der an seinem Eingang die Summe der Eingangsspannung ($V_e$) und einer Vergleichsspannung ($V_o$) empfängt, und einen zweiten Wandler (21), der das Komplement der Eingangsspannung ($V_e$) und der Referenzspannung ($V_o$) empfängt.

9. Vorrichtung nach einem der vorhergehenden Ansprüche, dadurch gekennzeichnet, daß sie wenigstens einen für das umzuwandelnde Signal bestimmten Umwandlungskanal (X, Y, Z), einen Substitutionskanal (S), der die Umwandlung des Signals während der Eichungsphasen des Wandlerkanals gewährleistet, sowie Kommutationsmittel ($M_1$, $M_2$, $M_3$) umfaßt, welche die Erzeugung des Signals auf dem Substitutionskanal (S) während der Eichungsphase und die Erzeugung der Stimuli auf dem Wandlerkanal (X, Y, Z) erlauben.

**10.** Vorrichtung nach Anspruch 9, dadurch gekennzeichnet, daß zu Beginn und/oder am Ende jeder Eichungsphase eine Erholzeit (R) vorgesehen ist, in deren Verlauf die über den Umwandlungskanal (X, Y, Z) gesendeten Informationen mit den über den Substitutionskanal (S) gesendeten Informationen verglichen werden.

**Claims**

**1.** Device for converting an electric signal ($V_e$) into a frequency,
characterized in that it comprises:

- at least two signal-to-frequency converters (5, 6) by channel, these converters (5, 6) each generating an intermediary frequency ($F_1$, $F_2$) which is a function of the input electric signal ($V_e$) to be converted, according to respective symmetrical transfer functions,
- a computer (3) enabling debiassing of the errors, and calculation of an estimation of the input quantity ($V_e$) from the intermediary frequencies ($F_1$, $F_2$), taking into account the particularities of said transfer functions.

**2.** Device according to claim 1,
characterized in that it comprises an autocalibration device using:

- a stimulating means (14) enabling the generation, in relation to the transfer function, of a sufficient number of stimuli to enable the computer ($N_u$) to determine, by means of a previously established model, the characteristic parameters of said transfer function,
- a switching means ($M_1$, $M_2$, $M_3$) enabling the performance of autocalibration sequences comprising the application of stimuli to the input of one of the converters (CX, CY, CZ), then, when the computer ($N_u$) has determined the aforesaid parameters, application of the input signal ($V_e$) to said converter (CX, CY, CZ).

**3.** Device according to either claim 1 or claim 2,
characterized in that the input signal consists of a voltage ($V_e$), and in that, in this case, one of the converters (5, 6) used has a transfer function according to which the frequency is an affine function of the input voltage ($V_e$) for positive values of this voltage ($V_e$), and is constant for negative values of this voltage, whereas the other converter (6) has a symmetrical transfer function, the frequency being an affine function of the input voltage ($V_e$) for negative values of the latter and a constant for positive values thereof.

**4.** Device according to claim 3,
characterized in that the stimuli enabling the computer to determine the characteristic parameters of the transfer function consist, for each of the converters (5, 6), of two voltages VEN - VON taken on the part of the curve representative of the transfer function corresponding to negative voltages, and of two voltages VOP, VEP taken on the part of the curve corresponding to positive voltages.

**5.** Device according to any one of the previous claims,
characterized in that it comprises two identical voltage-to-frequency converters (20, 21) connected by two respective links to the positive and negative outputs of a circuit (7, $D_1$,$D_2$) which receives the input voltage ($V_e$) to be converted, one of said links comprising a summing integrator (9) to which a reference voltage ($V_o$) is applied, whereas the other link comprises an inverse amplifier (10) and a summing integrator (11) to which the reference voltage ($V_o$) is applied.

**6.** Device according to claim 1 or claim 2,
characterized in that the transfer functions of the two converters (5, 6) consist of affine functions that are asymmetrical in relation to the point corresponding to a zero voltage of frequency Fo.

**7.** Device according to claim 6,
characterized in that the stimuli enabling the computer to determine the characteristic parameters of the transfer function consist of three voltages (stimuli), namely a voltage having a positive value VEP, a voltage having a negative value VEN and a voltage having a zero value OV.

**8.** Device according to either claim 6 or claim 7,
characterized in that it comprises two identical voltage-to-frequency converters (20, 21), namely a first converter (20) which receives, at its input, the sum of the input voltage ($V_e$) and a reference voltage ($V_o$), and a second

converter (21) which receives the sum of the complement of said input voltage ($V_e$) and said reference voltage ($V_o$).

9. Device according to any one of the previous claims,
characterized in that it comprises at least one conversion channel (X, Y, Z) assigned to the signal to be converted, a substitution channel (S) capable of converting said signal during calibration phases of the conversion channel and a switching means ($M_1$, $M_2$, $M_3$) enabling, during each calibration phase, the signal to be applied to the substitution channel (S) and stimuli to be applied to the conversion channel (X, Y, Z).

10. Device according to claim 9,
characterized in that, at the start and/or end of each calibration phase, there is provided a recovery time (R) during which the data transmitted by the conversion channel (X, Y, Z) are compared with the data transmitted by the substitution channel (S).

FIG.1

FIG.2

FIG.3

FIG.4

FIG.5

| Voie X | | AC | | CO | | AC | |
|---|---|---|---|---|---|---|---|
| Voie Y | | CO | AC | | CO | | |
| Voie Z | | | CO | AC | CO | | |
| Voie S | CO | X | CO | Y | CO | Z | AC | CO | X |
| Phases de recouvrement | R | R R | R R | R | R | R R |

FIG.6

FIG.7